# EUROPEAN PATENT SPECIFICATION

(11) **EP 3 038 444 B1**
(45) Date of publication and mention of the grant of the patent: **20.03.2019**
(21) Application number: 14838383.9
(22) Date of filing: 25.08.2014
(51) Int. Cl.: H05K 13/08, G01B 11/30

(54) **SUBSTRATE INSPECTING METHOD AND SUBSTRATE INSPECTING SYSTEM USING SAME**
SUBSTRATPRÜFVERFAHREN UND DAZU GEHÖRIGES SUBSTRATPRÜFSYSTEM
PROCÉDÉ D'INSPECTION DE SUBSTRAT ET SYSTÈME D'INSPECTION DE SUBSTRAT L'UTILISANT

(30) Priority: 23.08.2013 KR 20130100454; 21.08.2014 KR 20140108752
(43) Date of publication of application: 29.06.2016
(73) Proprietor: Koh Young Technology Inc., Seoul 153-706 (KR)
(72) Inventor: KIM, Hee-Tae, Yongin-si Gyeonggi-do 446-916 (KR); AHN, Yong-Keun, Seoul 136-761 (KR); CHA, Won-Jae, Namyangju-si Gyeonggi-do 472-844 (KR)
(74) Representative: Zardi, Marco
(86) International application number: PCT/KR2014/007880
(87) International publication number: WO 2015/026212

(56) References cited:
- WO-A1-2007/061388
- JP-A- H 034 600
- JP-A- 2007 109 704
- JP-A- 2008 072 037
- KR-A- 20100 107 131
- KR-A- 20110 105 512
- KR-A- 20110 124 638
- US-A- 5 835 223

## Description

### [Technical Field]

The present invention relates to a board inspection method and a board inspection system using the same, and more particularly a board inspection method capable of increasing productivity and inspection efficiency and a board inspection system using the same.

### [Background Art]

Generally, at least one printed circuit board (PCB) is employed in an electronic device, and various circuit components such as a circuit pattern, a connection pad part, a driver chip electrically connected to the connection pad part, etc. are mounted on the PCB.

The PCB as the above is manufactured by forming solder in a pad region of a bare board and coupling terminals of an electronic element to the solder-formed region. Conventionally, a solder paste inspection (SPI) process, in which it is inspected whether solder is formed well in the pad region of the PCB, has been performed before an electronic element is mounted on a PCB, and an automated optical inspection (AOI), in which various types of defects are detected such that it is inspected whether the electronic element is mounted well on the PCB, has been performed after an electronic element is mounted on a PCB.

However, in the PCB, defects of a bare board before soldering are not checkable with the inspections as the above process. These defects not only increase possibility of incurring defects such as wrong insertion or missing of elements in mounting electronic elements, but also produce many defective products by mounting electronic elements on an originally defective bare board so that unnecessary processes are performed, thereby deteriorating productivity and efficiency of inspection.

US 5835223 A discloses a system for measuring surface characteristics of an electronic interconnection component, such as a printed circuit board, by analyzing shadow moiré patterns. JP H03 4600 A discloses an electronic component mounting device where a sensor is provided under a printed board, and the degree of warpage epsilon of the board is measured as a vertical displacement.

### [Disclosure]

### [Technical Problem]

Therefore, a technical problem of the present invention is to provide a board inspection method capable of increasing productivity and inspection efficiency.

Another technical problem of the present invention is to provide a board inspection system capable of increasing productivity and inspection efficiency.

### [Technical Solution]

The above technical problem is solved by the method and inspection system of the annexed claims.

In an exemplary embodiment of the present invention, a board inspection method includes transferring a board prior to mounting an element on the board by a mounter to a work stage, inspecting warpage of the board, transferring the board to the mounter in case that the board is judged good as a result of the inspection, and finally determining the board no good without transferring the board to the mounter in case that the board is judged no good as the result of the inspection.

In an exemplary embodiment, inspecting warpage of the board may include judging whether warpage exists in the board, judging the board good in case that warpage does not exist in the board, checking a warpage degree of the board in case that warpage exists in the board, judging the board good in case that the warpage degree of the board is within a tolerance band, and judging the board no good in case that the warpage degree of the board is not within a tolerance band. The board inspection method may further include displaying the warpage of the board in a 3D image, before checking a warpage degree of the board in case that warpage exists in the board.

In an exemplary embodiment, the board inspection method may further include transmitting warpage information of the board to the mounter in case that the board is judged good as the result of the inspection. For example, the warpage information may include at least one information of warpage coordinate, warpage shape, warpage for each region, and warpage degree.

Herein, the board inspection method may further include receiving feedback for responsive result information according to the warpage information from the mounter and performing statistical analysis for the responsive result information and production of additional responsive plan.

In an exemplary embodiment, the board inspection method may further include judging the board partially good in case that warpage exists in a partial region of the board and warpage does not exist or is within the tolerance band in a remaining region, and transferring the board to the mounter in case that the board is judged partially good as the result of the inspection. In addition, the board inspection method may further include transmitting the warpage information of the board to the mounter in case that the board is judged partially good as the result of the inspection. For example, the warpage information may include command of mount or no-mount for each region.

In an exemplary embodiment, before inspecting warpage of the board, the board inspection method may further include acquiring height information of the board, and inspecting warpage of the board may be performed based on the acquired height information of the board. For example, acquiring height information of the board may include providing grating pattern light to the board, acquiring a pattern image of the grating pattern light reflected by the board, and calculating the height information of the board by using the acquired pattern image.

In an exemplary embodiment, the board inspection method, before inspecting warpage of the board, may further include measuring a distance between at least two identification marks formed on the board. In this case, inspecting warpage of the board may include comparing the distance between the identification marks with a reference distance.

In another exemplary embodiment of the present invention, a board inspection system includes a work stage transfer part, a warpage inspection part, and a mounter transfer part. The work stage transfer part transfers a board prior to mounting an element on the board by a mounter to a work stage. The warpage inspection part judges whether the board is good or no good by inspecting warpage of the board. The mounter transfer part transfers the board to the mounter in case that the board is judged good as a result of the inspection of the warpage inspection part.

In an exemplary embodiment, the warpage inspection part may include a warpage judging section judging whether warpage exists in the board, a warpage checking section checking a warpage degree of the board, in case that warpage exists in the board, and a board judging section judging the board good, in case that warpage does not exist in the board and the warpage degree of the board is within a tolerance band, and judging the board no good, in case that the warpage degree of the board is not within a tolerance band. The board judging section may judge the board partially good, in case that warpage exists in a partial region of the board and warpage does not exist or is within the tolerance band in a remaining region. The board inspection system may further include a transmitting part transmitting the warpage information of the board to the mounter, and the warpage information may include command of mount or no-mount for each region.

For example, the warpage inspection part may further include a display section displaying the warpage of the board in a 3D image. For example, the display section may include a shape display portion displaying a 3D shape of the board, a displayed shape control portion controlling the displayed 3D shape of the board and a warpage information display portion displaying information for the warpage of the board.

In an exemplary embodiment, the board inspection system may further include a height information acquiring part acquiring height information of the board. The warpage inspection part may inspect the warpage of the board based on the height information of the board acquired by the height information acquiring part. For example, the height information acquiring part may include a projecting section providing grating pattern light to the board, a camera section acquiring a pattern image of the grating pattern light reflected by the board and a control section calculating the height information of the board by using the acquired pattern image.

In an exemplary embodiment, the board inspection system may further include a distance measuring part measuring a distance between at least two identification marks formed on the board, and the warpage inspection part may inspect the warpage of the board by comparing the distance between the identification marks with a reference distance.

The warpage inspection part may perform statistical analysis for the responsive result information and production of additional responsive plan in case of receiving feedback for responsive result information according to the warpage information from the mounter.

### [Advantageous Effects]

According to the present invention, warpage of a board prior to mounting an element on the board is inspected, and then a board judged no good is not transferred to a mounter but finally determined no good in advance, thereby preventing unnecessary works and defective products beforehand, and increasing productivity and efficiency of inspection.

In addition, information for shape and warpage of the inspected board is displayed, so that a worker may easily grasp and check warpage formed in the board, and control a shape of the displayed board by using a specific input tool and establish a tolerance band of warpage.

### [Description of Drawings]

FIG.1 is a flow chart illustrating a board inspection method according to an exemplary embodiment of the present invention.
FIG. 2 is flow chart illustrating an exemplary embodiment of a process of inspecting warpage of a board in the board inspection method in FIG. 1.
FIG. 3 is a conceptual view illustrating a board inspection system according to an exemplary embodiment of the present invention.
FIG. 4 is a block diagram illustrating an example of a warpage inspecting section of the board inspection system in FIG. 4.
FIG. 5 is a conceptual view illustrating an example of a displayed screen performed by a display part of the warpage inspecting section in FIG. 4.

### [Mode for Invention]

The present invention is described more fully hereinafter with reference to the accompanying drawings, in which example embodiments of the present invention are shown. The present invention may, however, be embodied in many different forms and should not be construed as limited to the example embodiments set forth herein. Rather, these example embodiments are provided so that this disclosure will be thorough and complete, and will fully convey the scope of the present invention to those skilled in the art. In the drawings, the sizes and relative sizes of layers and regions may be exaggerated for clarity.

It will be understood that, although the terms first, second, third etc. may be used herein to describe various elements, components, regions, layers and/or sections, these elements, components, and/or sections should not be limited by these terms. These terms are only used to distinguish one element, component, region, layer or section from another region, layer or section. Thus, a first element, component, or section discussed below could be termed a second element, component, or section without departing from the teachings of the present invention.

The terminology used herein is for the purpose of describing particular example embodiments only and is not intended to be limiting of the present invention. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs.

It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, with reference to the drawings, preferred embodiments of the present invention will be described in detail.

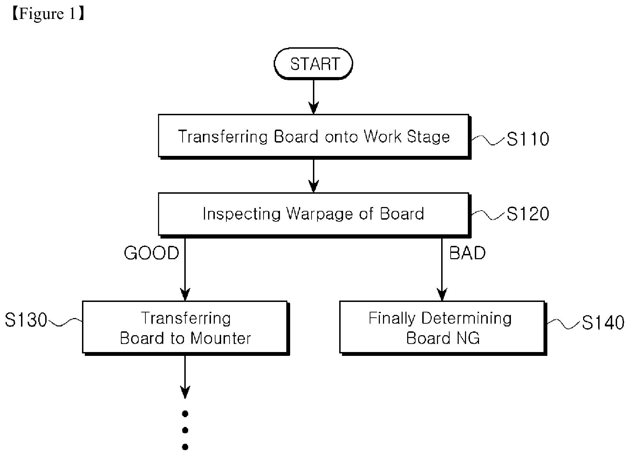

FIG.1 is a flow chart illustrating a board inspection method according to an exemplary embodiment of the present invention.

Referring to FIG. 1, in order to inspect a board according to an exemplary embodiment of the present invention, first, a board prior to mounting an element on the board by a mounter is transferred to a work stage in step of S110.

Then, warpage of the board is inspected in step of S120. The warpage of the board may occur in case that the board is manufactured defective at first, bending occurs after manufacturing the board, a thickness of the board is thin in comparison with a size thereof, etc. Thus, curve or deflection exists in the board, to thereby incur the warpage.

Thereafter, the board is transferred to the mounter in case that the board is judged good as a result of the inspection in step of S130.

Particularly, in case that the board is judged good by the warpage inspection in step of S120, the board is transferred to the mounter and then elements are mounted on the board, which is the same as a conventional case.

Then, in case that the board is judged no good as the result of the inspection, the board is finally determined no good without transferring the board to the mounter in step of S140.

Particularly, in case that the board is judged no good by the warpage inspection in step of S120, the board is immediately determined no good without performing processes of transferring the board to the mounter and mounting elements on the board as usual.

Thus, when warpage is serious, prior to performing a process of mounting elements on the board, the board is finally determined no good in advance, thereby preventing wrong insertion or missing of elements in mounting elements on the board using the mounter, or inspection errors in inspecting the board.

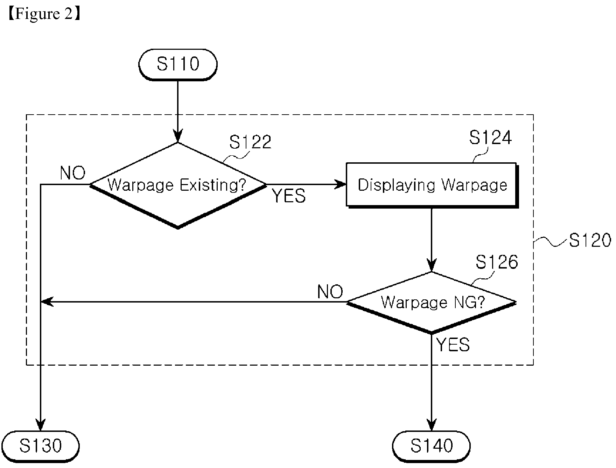

FIG. 2 is flow chart illustrating an exemplary embodiment of a process of inspecting warpage of a board in the board inspection method in FIG. 1.

Referring to FIG. 2, an exemplary embodiment of a process of inspecting the warpage of the board, first, it is judged whether warpage exists in the board in step of S122.

For example, judging whether warpage exists in the board may be performed based on image data that is acquired by 3-dimensional (3D) shape measurement.

In an exemplary embodiment, before inspecting the warpage of the board, height information of the board may be previously acquired. A process of inspecting the warpage of the board may be performed based on the acquired height information of the board. For example, in order to acquire the height information of the board, grating pattern light may be provided to the board, and a pattern image of the grating pattern light reflected by the board may be acquired. Thereafter, the height information of the board may be calculated by using the acquired pattern image. Herein, the grating pattern light provided to the board may performed by N times while moving a grating unit (N is a natural number that is greater than or equal to 2), and the height information of the board may be calculated by using a bucket algorithm.

Before inspecting the warpage of the board, a distance between at least two identification marks formed on the board may be measured. In this case, a process of inspecting the warpage of the board may be performed by comparing the distance between the identification marks with a reference distance.

In case that warpage does not exist in the board as the result of judging whether warpage exists in the board, the board is judged good. Particularly, in case that warpage does not exist in the board as the result of inspecting the warpage, the board is judged good.

In addition, in case that warpage exists in the board, a warpage degree of the board is checked in step of S 126. The board is judged good in case that the warpage degree of the board is within a tolerance band, and the board is judged no good in case that the warpage degree of the board is not within a tolerance band.

As described above, in case that the board is judged good since the warpage degree of the board is within a tolerance band as the result of checking the warpage degree of the board, the board is transferred to the mounter in step of S130. Herein, information about the warpage and information about judgment result (hereinafter, referred to as "warpage information") may be transmitted to the mounter, and the warpage information may include information of warpage coordinate, information of warpage shape, information of warpage for each region, information of warpage degree, etc.

In addition, when warpage exists in a partial region of the board but warpage does not exist or is within the tolerance band in other region (i.e., good region), elements are mountable on the good region. Thus, the board may be judged partially good and transferred to the mounter in step of S130. The warpage information may be transferred to the mounter, and the warpage information may include information of warpage coordinate, information of warpage shape, information of warpage for each region, information of warpage degree, command of mount or no-mount for each region, etc.

Before checking the warpage degree of the board in step of S126, the warpage of the board may be displayed in a 3D image in step of S 124.

Checking the degree of the warpage and establishing the tolerance band may be automatically performed through a computer, etc., based on criterion and information that are previously input. Alternatively, checking the degree of the warpage and establishing the tolerance band may be manually performed through a worker, based on the displayed 3D image.

Hereinafter, an exemplary embodiment of a board inspection system for performing the above board inspection method will be described in detail with reference to the accompanying drawings.

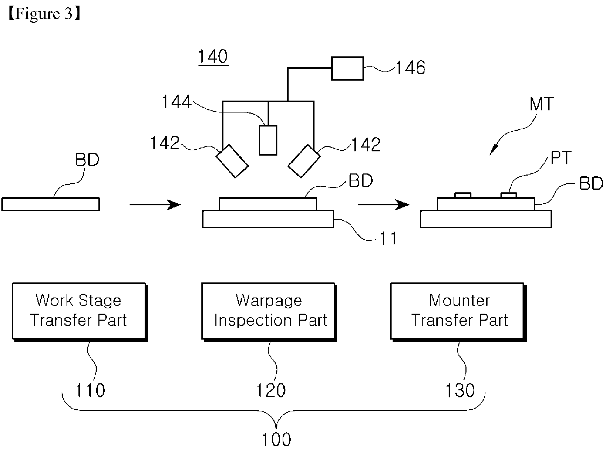

FIG. 3 is a conceptual view illustrating a board inspection system according to an exemplary embodiment of the present invention.

Referring to FIG. 3, a board inspection system 100 according to an exemplary embodiment of the present invention include a work stage transfer part 110, a warpage inspection part 120 and a mounter transfer part 130.

The work stage transfer part 110 transfers a board BD prior to mounting an element PT on the board BD by a mounter MT to a work stage. The work stage transfer part 110 may perform a process of transferring the board to a work stage in step of S110 shown in FIGS. 1 and 2.

The warpage inspection part 120 judges whether the board BD is good or no good by inspecting warpage of the board BD. The warpage inspection part 120 may perform a process of inspecting the warpage of the board in step of S120 S110 shown in FIGS. land 2.

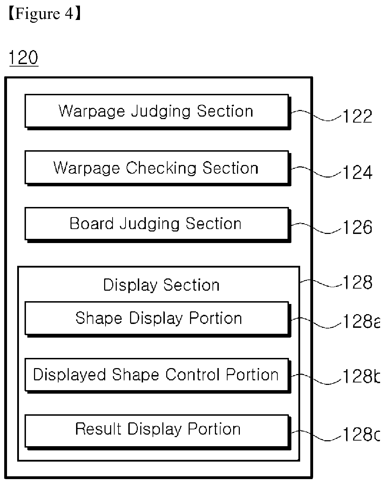

FIG. 4 is a block diagram illustrating an example of a warpage inspecting section of the board inspection system in FIG. 4.

Referring to FIG. 4, in an exemplary embodiment, the warpage inspection part 120 may include a warpage judging section 122, a warpage checking section 124 and a board judging section 126.

The warpage judging section 122 judges whether warpage exists in the board BD. The warpage judging section 122 may perform a process of judging whether warpage exists in the board BD in step of S122 shown in FIGS. 1 and 2.

The warpage checking section 124 checks a warpage degree of the board BD, in case that warpage exists in the board BD. The warpage checking section 124 may perform a process of checking a warpage degree of the board BD in step of S126 shown in FIGS. 1 and 2.

The board judging section 126 judges the board BD good in case that warpage does not exist in the board BD and the warpage degree of the board BD is within a tolerance band, and judges the board BD no good in case that the warpage degree of the board BD is not within a tolerance band. The board judging section 126 may perform a process substantially the same process of judging whether the board is good or no good in a process of inspecting the warpage of the board in step of S 120 shown in FIGS. 1 and 2.

The warpage inspection part 120 may further include a display section 128 displaying the warpage of the board BD in a 3D image.

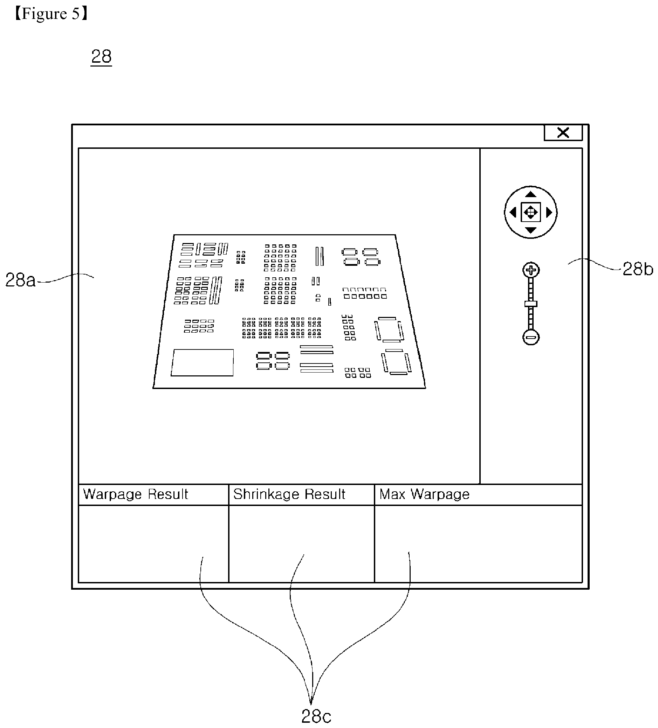

FIG. 5 is a conceptual view illustrating an example of a displayed screen performed by a display part of the warpage inspecting section in FIG. 4.

Referring to FIGS. 4 and 5, the display section 128 may perform a process of displaying the warpage of the board BD in a 3D image in step of S120 shown in FIGS. 1 and 2, and the 3D image may be displayed on a screen 28 of a device such as a monitor.

In an exemplary embodiment, the display section 128 may include a shape display portion 128a, a displayed shape control portion 128b and a warpage information display portion 128c.

The shape display portion 128a displays 3D shape of the board BD so that a worker may easily grasp a warpage degree or a shape of the board BD. In an exemplary embodiment, a 3D shape 28a of the board BD may be displayed on a screen 28 of a device such as a monitor shown in FIG. 5.

The displayed shape control portion 128b controls the displayed 3D shape 28a of the board BD automatically or by receiving a viewing direction, a magnification ratio, etc. of the displayed board BD through a worker. In an exemplary embodiment, the displayed 3D shape 28a of the board BD may be controlled based on input methods through an input device such as a mouse or a keyboard, or through a touch screen by using a shape control tool 28b displayed on the screen 28 of a device such as a monitor shown in FIG. 5. For example, the viewing direction of the board BD may be controlled by using an upper tool of the shape control tool 28b, and the magnification ratio of the board BD may be controlled by using a lower tool of the shape control tool 28b.

The warpage information display portion 128c displays information for the warpage of the board BD. In an exemplary embodiment, warpage information 28c including a result of warpage (Warpage Result), a result of shrinkage (Shrinkage Result), a maximum of warpage (Max Warpage), etc. may be displayed on the screen 28 of a device such as a monitor shown in FIG. 5. The result of warpage is a result of measuring warpage existing in the board BD, and may include a maximum height, a minimum height, a height difference, an offset, etc. of the board BD. The result of shrinkage is information for shrinkage of the board BD, and may include a degree of shrinkage, an offset in an x-axis direction, and an offset in a y-axis direction. The maximum of warpage is a tolerance band of warpage. A previously determined value or an automatically produced value according to a type of the board BD may be displayed, and alternatively, or additionally, a worker may input or modify the maximum of warpage.

Referring again to FIG. 4, the mounter transfer part 130 transfers the board BD to the mounter MT in case that the board BD is judged good as the result of the inspection by the warpage inspection part 120. The mounter transfer part 130 may perform a process of transferring the board BD to the mounter MT in step of S130 shown in FIGS. 1 and 2.

The mounter MT may receive the warpage information as described in FIG. 2. The mounter MT may mount an element PT on the board BD based on the received warpage information, and a speed, a height, etc. of an associated head may be controlled by using the warpage information. In addition, the mounter MT may give a solder inspection apparatus (not shown) feedback concerning responsive result information according to the warpage information. In this case, the solder inspection apparatus may analyze the responsive result information, and statistically analyzes the responsive result information or produces an additional responsive plan.

For an example of the additional responsive plan, in case that the board BD is judged good since the warpage degree of the board BD is within a tolerance band, or in case that the board BD is judged good since warpage exists in a partial region of the board BD but warpage does not exist or is within a tolerance band in other region, it may occur that the mounter MT does not mount an element on the board BD or a specific region of the board BD, although associated information is transmitted to the mounter MT. In this case, the tolerance band may be reduced by a unit that is previously established. In addition, information for a speed, a height, a maximum twist and a mounting angle of a head may be transmitted from the mounter MT before inspecting warpage, and compared with information included in the responsive result information, thereby judging abnormality of the head and displaying the judged result information or re-transmitting the judged result information to the mounter MT.

In an exemplary embodiment, the board inspection system 100 may include a height information acquiring part 140 acquiring height information of the board BD.

The warpage inspection part 120 inspects the warpage of the board BD based on the height information of the board BD acquired by the height information acquiring part 140.

For example, the height information acquiring part 140 includes a projecting section 142, a camera section 144 and a control section 146. The projecting section 142 provides grating pattern light to the board BD. The camera section 144 acquires a pattern image of the grating pattern light reflected by the board BD. The control section 146 calculates the height information of the board BD by using the acquired pattern image. The height information acquiring part 140 may perform a process of measuring height shown in FIGS. 1 and 2.

In an exemplary embodiment, the board inspection system 100 may further include a distance measuring part (not shown) measuring a distance between at least two identification marks formed on the board BD, and the warpage inspection part 120 inspects the warpage of the board BD by comparing the distance between the identification marks with a reference distance.

According to a board inspection method and a board inspection system as described above, warpage of a board prior to mounting an element on the board is inspected, and then a board judged no good is not transferred to a mounter but finally determined no good in advance, thereby preventing unnecessary works and defective products beforehand, and increasing productivity and efficiency of inspection.

In addition, information for shape and warpage of the inspected board is displayed, so that a worker may easily grasp and check warpage formed in the board, and control a shape of the displayed board by using a specific input tool and establish a tolerance band of warpage.

It will be apparent to those skilled in the art that various modifications and variation can be made in the present invention without departing from the scope of the invention, which is defined by the appended claims. Thus, it is intended that the present invention cover the modifications and variations of this invention provided they come within the scope of the appended claims and their equivalents.

## Claims

1. A board inspection method of inspecting whether a board is good or no good, which is performed by a board inspecting apparatus, the board inspection method comprising:
transferring a board on which solder is formed to a work stage (S110); and
inspecting warpage of the board (S120) based on height information measured by providing a plurality of pattern lights or a distance between at least two identification marks formed on the board,
**characterized by** further comprising: in case that a warpage degree is within a tolerance in the board as a result of the inspection, transmitting information for the warpage to a mounter (S130); and
in case that the warpage degree is not within the tolerance in a partial region of the board and that the warpage does not exist or the warpage degree is within the tolerance in a remaining region, transmitting the information for the warpage including command of mount or no-mount for each region to the mounter (S140).

2. The board inspection method of claim 1, after inspecting warpage of the board, further comprising displaying the tolerance for checking the warpage degree of the board, and a 3D image of the warpage of the board.

3. The board inspection method of claim 2, when displaying the tolerance for checking the warpage degree of the board, and a 3D image of the warpage of the board,
a result of warpage (Warpage Result) that includes at least one of a maximum height, a minimum height, a height difference and an offset, a result of shrinkage (Shrinkage Result) that includes at least one of a degree by which the board shrinks, an offset in an x-axis direction and an offset in a y-axis direction, and a maximum of warpage (Max Warpage) corresponding to a maximum tolerance are displayed.

4. The board inspection method of claim 1, wherein the information for the warpage includes at least one information of warpage coordinate, warpage shape, and warpage degree.

5. The board inspection method of claim 1, further comprising:
receiving feedback for responsive result information according to the information for the warpage from the mounter; and
performing statistical analysis for the responsive result information.

6. A board inspection system (100) comprising:
a warpage inspection part (120) for judging whether a board (BD), on which solder is formed, is good or no good, by inspecting warpage of the board (BD), and transmitting information for the warpage to a mounter (MT); and
the mounter (MT) for mounting an element (PT) on said board (BD) by controlling at least one of a speed, a height and an angle of a head based on the information for the warpage, and providing feedback to a solder inspection part with responsive result information according to the warpage information,
wherein said warpage inspection part (120) is adapted to transmit information for the warpage to the mounter (MT) in case that a warpage degree is within a tolerance in the board as a result of the inspection; and
wherein said warpage inspection part (120) is adapted to transmit information for the warpage to the mounter (MT) including command of mount or no-mount for each region in case that the warpage degree is not within the tolerance in a partial region of the board (BD) and that the warpage does not exist or is within the tolerance in a remaining region.

7. A board inspection system of claim 6, wherein the solder inspection part is adapted to perform statistical analysis for the responsive result information.

## Patentansprüche

1. Plattenprüfverfahren zum Prüfen, ob eine Platte gut oder nicht gut ist, das durch eine Plattenprüfvorrichtung durchgeführt wird, wobei das Plattenprüfverfahren umfasst:
Übertragen einer Platte, auf der ein Lötmittel gebildet ist, zu einem Arbeitstisch (S110); und
Prüfen einer Wölbung der Platte (S120) basierend auf einer Höheninformation, die durch Bereitstellen einer Vielzahl von Musterlichtern oder eines Abstands zwischen wenigstens zwei an der Platte gebildeten Identifikationsmarkierungen gemessen wird,
**dadurch gekennzeichnet, dass** es ferner umfasst: falls als ein Ergebnis der Prüfung ein Wölbungsgrad in der Platte innerhalb einer Toleranz ist, Übermitteln einer Information über die Wölbung zu einem Mounter (S130); und
falls ein Wölbungsgrad in einem Teilbereich der Platte nicht innerhalb der Toleranz ist und in einem verbleibenden Bereich keine Wölbung existiert oder der Wölbungsgrad innerhalb der Toleranz ist, Übermitteln der Information über die Wölbung umfassend einen Befehl zur Montage oder Nicht-Montage für jeden Bereich zu dem Mounter (S140).

2. Plattenprüfverfahren nach Anspruch 1, das nach Prüfen der Wölbung der Platte ferner ein Anzeigen der Toleranz zum Überprüfen des Wölbungsgrads der Platte und eines 3D-Bilds der Wölbung der Platte umfasst.

3. Plattenprüfverfahren nach Anspruch 2, wobei beim Anzeigen der Toleranz zum Überprüfen des Wölbungsgrads der Platte und eines 3D-Bilds der Wölbung der Platte ein Ergebnis für eine Wölbung (Wölbungsergebnis), das eine maximale Höhe, eine minimale Höhe, einen Höhenunterschied und/oder einen Offset umfasst, ein Ergebnis für eine Schrumpfung (Schrumpfungsergebnis), das einen Grad, um den die Platte schrumpft, einen Offset in einer x-Achsen-Richtung und/oder einen Offset in einer y-Achsen-Richtung umfasst, und ein Maximum einer Wölbung (Wölbungsmax.) entsprechend einer maximalen Toleranz angezeigt werden.

4. Plattenprüfverfahren nach Anspruch 1, wobei die Information für die Wölbung eine Information über eine Schrumpfungskoordinate, eine Schrumpfungsform und/oder einen Schrumpfungsgrad umfasst.

5. Plattenprüfverfahren nach Anspruch 1, ferner umfassend:
Empfangen von Feedback für eine Reaktionsergebnisinformation gemäß der Information für die Wölbung von dem Mounter; und
Durchführen einer statistischen Analyse für die Reaktionsergebnisinformation.

6. Plattenprüfsystem (100) umfassend:
ein Wölbungsprüfteil (120) zum Beurteilen, ob eine Platte (BD), auf der ein Lötmittel gebildet ist, gut oder nicht gut ist, durch Prüfen einer Wölbung der Platte (BD) und Übermitteln einer Information über die Wölbung zu einem Mounter (MT); und
den Mounter (MT) zum Montieren eines Elements (PT) auf der Platte (BD) durch Steuern einer Geschwindigkeit, einer Höhe und/oder eines Winkels eines Kopfs basierend auf der Information über die Wölbung, und Bereitstellen von Feedback für ein Lötmittelprüfteil mit einer Reaktionsergebnisinformation gemäß der Wölbungsinformation,
wobei das Wölbungsprüfteil (120) daran angepasst ist, eine Information über die Wölbung zu dem Mounter (MT) zu übertragen, falls als ein Ergebnis der Prüfung ein Wölbungsgrad in der Platte innerhalb einer Toleranz ist; und
wobei das Wölbungsprüfteil (120) daran angepasst ist, eine Information über die Wölbung zu dem Mounter (MT) zu übertragen, die einen Befehl zur Montage oder Nicht-Montage für jeden Bereich umfasst, falls ein Wölbungsgrad in einem Teilbereich der Platte nicht innerhalb der Toleranz ist und in einem verbleibenden Bereich keine Wölbung existiert oder der Wölbungsgrad innerhalb der Toleranz ist.

7. Plattenprüfverfahren nach Anspruch 6, wobei das Lötmittelprüfteil daran angepasst ist, eine statistische Analyse für die Reaktionsergebnisinformation durchzuführen.

## Revendications

1. Procédé d'inspection de carte destiné à inspecter si une carte est correcte ou incorrecte, lequel est réalisé à l'aide d'un dispositif d'inspection de carte, le procédé d'inspection de carte consistant à :
- transférer une carte sur laquelle une soudure est formée vers une étape de travail (S110) ; et
- inspecter le gauchissement de la carte (S120) sur la base d'informations de hauteur mesurées en fournissant une pluralité de lumières de motifs ou une distance entre au moins deux marques d'identification formées sur la carte ;
**caractérisé en ce qu'**il consiste en outre, dans le cas où un degré de gauchissement est compris dans une tolérance dans la carte suite au résultat d'inspection, à transmettre des informations relatives au gauchissement à un monteur (S130) ; et
dans le cas où le degré de gauchissement n'est pas compris dans la tolérance dans une zone partielle de la carte et où le gauchissement n'existe pas ou le degré de gauchissement est compris dans la tolérance dans une zone résiduelle, à transmettre au monteur les informations relatives au gauchissement comprenant la commande de montage ou de non-montage pour chaque zone (S140).

2. Procédé d'inspection de carte selon la revendication 1, après l'inspection du gauchissement de la carte, consistant en outre à :
- afficher la tolérance pour contrôler le degré de gauchissement de la carte et une image 3D du gauchissement de la carte.

3. Procédé d'inspection de carte selon la revendication 2, lors de l'affichage de la tolérance pour contrôler le degré de gauchissement de la carte, et une image 3D du gauchissement de la carte,
sont affichés un résultat de gauchissement (Résultat de Gauchissement) qui comprend au moins un élément parmi une hauteur maximum, une hauteur minimum, une différence de hauteur et un décalage, un résultat de retrait (Résultat de Retrait) qui comprend au moins un élément parmi un degré selon lequel la carte produit un retrait, un décalage dans la direction d'un axe x et un décalage dans la direction d'un axe y, et un maximum de gauchissement (Gauchissement Max) correspondant à une tolérance maximale.

4. Procédé d'inspection de carte selon la revendication 1, où les informations relatives au gauchissement comprennent au moins une information de coordonnée de gauchissement, une forme de gauchissement, et un degré de gauchissement.

5. Procédé d'inspection de carte selon la revendication 1, consistant en outre à :
- recevoir un retour relatif aux informations de résultat en réponse en fonction des informations relatives au gauchissement en provenance du monteur ; et
- réaliser une analyse statistique relative aux informations de résultat en réponse.

6. Système d'inspection de carte (100) comportant :
- une partie d'inspection de gauchissement (120) pour juger si une carte (BD), sur laquelle une soudure est formée, est correcte ou incorrecte, en inspectant le gauchissement de la carte (BD), et transmettre des informations relatives au gauchissement à un monteur (MT) ; et
- le monteur (MT) pour monter un composant (PT) sur ladite carte (BD) en commandant au moins un élément parmi une vitesse, une hauteur et un angle d'une tête sur la base des informations relatives au gauchissement, et fournir un retour à une partie d'inspection de soudure avec des informations de résultat en réponse en fonction des informations de gauchissement,
**caractérisé en ce que** ladite partie d'inspection de gauchissement (120) est adaptée pour transmettre des informations relatives au gauchissement au monteur (MT) dans le cas où un degré de gauchissement est compris dans une tolérance dans la carte suite au résultat d'inspection ; et
**en ce que** ladite partie d'inspection de gauchissement (120) est adaptée pour transmettre au monteur (MT) des informations relatives au gauchissement comprenant la commande de montage ou de non-montage pour chaque zone dans le cas où le degré de gauchissement n'est pas compris dans la tolérance dans une zone partielle de la carte (BD) et où le gauchissement n'existe pas ou est compris dans la tolérance dans une zone résiduelle.

7. Système d'inspection de carte selon la revendication 6, où la partie d'inspection de soudure est adaptée pour réaliser une analyse statistique pour les informations de résultat en réponse.
